# FASCICULE DE BREVET EUROPEEN

(11) **EP 2 498 287 B1**
(45) Date de publication et mention de la délivrance du brevet: **12.11.2014**
(21) Numéro de dépôt: 12158256.3
(22) Date de dépôt: 06.03.2012
(51) Int. Cl.: H01L 21/768, H01L 23/48, B81C 1/00

(54) **Procédé de réalisation d'interconnexions verticales à travers des couches structurées.**
Verfahren zur Herstellung von vertikalen Verbindungen durch strukturierte Schichten hindurch
Method for making vertical interconnections through structured layers

(30) Priorité: 09.03.2011 FR 1100701
(43) Date de publication de la demande: 12.09.2012
(73) Titulaire: Commissariat à l'Énergie Atomique et aux Énergies Alternatives, 75015 Paris (FR)
(72) Inventeur: Berthelot, Audrey, 38330 ST ISMIER (FR); Polizzi, Jean-Philippe, 38000 GRENOBLE (FR)
(74) Mandataire: Reboussin, Yohann Mickaël Noël

(56) Documents cités:
- FR-A1- 2 928 225
- US-A1- 2008 083 976
- US-A1- 2010 155 932
- US-A1- 2010 244 251

## Description

La présente invention a pour objet un procédé de réalisation d'au moins un puits d'interconnexion en vue de la réalisation d'interconnexions ou vias dans un composant comportant au moins deux substrats.

On entend par composant tout dispositif réalisant au moins une fonction, électrique et/ou mécanique et/ou chimique et comportant des interfaces électriques.

US2008/0083976 décrit un procédé pour connecter une pluralité des composants microélectroniques superposés ayant des zones dépourvues de matière et comportant une étape de coupure mécanique pour réaliser les connexions.

Une interconnexion ou via permet de connecter électriquement à la surface du composant des zones de contact situées dans une ou plusieurs couches de connexion enterrées à des niveaux différents.

Dans les procédés connus, la réalisation d'interconnexions ou vias s'effectue par étapes successives, à raison d'une étape de réalisation à travers les substrats (ou à travers une couche isolante au cas où deux couches d'interconnexions sont séparés seulement par une couche isolante) de régions de passage suivie d'une étape de remplissage de celles-ci, pour chaque couche d'interconnexion, au fur et à mesure de la réalisation de l'empilement, les couches d'interconnexion étant situées à des niveaux différents de l'empilement.

Autrement dit, dans le cas de trois couches de connexion, on réalise au moins une région de passage pour le ou les motifs conducteurs de la première couche de connexion, que l'on remplit d'un matériau conducteur pour former un tronçon d'interconnexion formant une partie de l'interconnexion.

Ensuite, pour la deuxième couche de connexion, on réalise à travers une couche isolante qui sépare la première et la deuxième couches de connexion ou à travers le deuxième substrat, au moins une région de passage pour le ou les motifs conducteurs de la deuxième couche de connexion, ainsi qu'au moins une région de passage pour prolonger la portion du via vers la première couche de connexion, et ainsi de suite pour le troisième substrat.

Ainsi, des étapes similaires sont répétées plusieurs fois au cours de la fabrication, pour réaliser les interconnexions par tronçons, ce qui augmente d'autant les coûts de fabrication.

La présente invention propose d'éviter cet inconvénient grâce à un procédé qui permet de réaliser en une seule étape au moins deux tronçons d'une interconnexion.

L'idée de base de l'invention est que lors de la gravure d'un puits, dont le parcours traverse un espace dépourvu de matière, les ions du plasma de gravure traversent cet espace sans être ralentis , arrêtés ou déviés, et qu'au-delà de cette espace, la gravure du puits peut être poursuivie en conservant sa section.

L'invention concerne ainsi un procédé de réalisation d'au moins un puits d'interconnexion destiné à permettre la réalisation d'un via conducteur entre au moins deux couches de connexion d'un composant comprenant un empilement d'au moins un premier et un deuxième substrats isolés électriquement entre eux, le procédé comprenant la définition d'au moins une zone de contact de surface d'une couche de connexion de surface sur une surface de l'empilement et d'au moins une première zone de contact enterrée dans l'empilement à partir d'une première couche de connexion enterrée du premier substrat, **caractérisé en ce qu'**au moins une zone dépourvue de matière est disposée entre le premier et le deuxième substrats et en ce qu'il comporte une étape de réalisation par gravure plasma à partir de ladite surface de l'empilement d'au moins un premier puits d'interconnexion traversant au moins le deuxième substrat et s'étendant entre la zone de contact de surface et la première zone de contact enterrée et traversant la zone dépourvue de matière, ainsi qu'une première couche isolante qui recouvre la première couche de connexion enterrée.

Le procédé peut être **caractérisé en ce qu'**il comporte une étape de remplissage du puits d'interconnexion par un matériau conducteur pour former un via conducteur et une étape de réalisation de ladite couche de connexion de surface, le via conducteur reliant électriquement par leurs dites zones de contact la première couche de connexion enterrée à la couche de connexion de surface.

Le procédé peut être **caractérisé en ce que** la première couche de connexion est ménagée dans une surface du premier substrat sur lequel est ensuite déposée ladite première couche isolante et en ce qu'il comporte les étapes suivantes :
a) après le dépôt de la première couche isolante, déposer sur celle-ci au moins une deuxième couche de connexion enterrée comportant une deuxième zone de contact enterrée, en laissant libre au moins une première zone dépourvue de matière pour le passage d'un via conducteur destiné à la première zone de contact enterrée de la première couche de connexion enterrée,
b) solidariser la deuxième couche de connexion enterrée au deuxième substrat semiconducteur par l'intermédiaire d'une deuxième couche isolante,
c) réaliser au moins le dit premier puits d'interconnexion, et simultanément, éventuellement un deuxième puits d'interconnexion s'étendant depuis ladite surface de l'empilement jusqu'à une zone de contact de la deuxième couche de connexion enterrée.

L'étape c peut être réalisée à partir de la surface du deuxième substrat, opposée à celle en contact avec la deuxième couche isolante.

La deuxième couche isolante peut ne pas faire partie du deuxième substrat et être déposée avant le report du deuxième substrat.

Alternativement, le procédé peut être **caractérisé en ce qu'**il met en oeuvre entre b et c :
b1) réaliser à la surface du deuxième substrat en contact avec ladite surface de la deuxième couche isolante au moins une troisième couche de connexion en laissant libre au moins une zone dépourvue de matière située à l'aplomb des zones de contact enterrées de chacun des première et deuxième couches de connexion,
b2) solidariser le troisième niveau de connexion à un troisième substrat, par l'intermédiaire d'une troisième couche isolante,

L'étape c) comporte de préférence la réalisation simultanée d'au moins un premier, un deuxième et/ou un troisième puits d'interconnexion pour au moins une des première, deuxième et troisième zones de contact.

L'étape c peut être réalisée à partir d'une surface du troisième substrat, opposée à celle en contact avec ladite troisième couche isolante.

La troisième couche isolante peut ne pas faire partie du troisième substrat et être déposée avant le report du troisième substrat.

Dans le cas d'une structure mettant en oeuvre trois substrats, il peut également n'y avoir qu'une seule couche de connexion enterrée (et non deux) entre le premier et le deuxième substrat, ainsi qu'une couche de connexion enterrée entre le deuxième et le troisième substrat.

Le procédé peut être alors **caractérisé en ce que** la première couche de connexion enterrée est ménagée dans une surface du premier substrat sur laquelle est ensuite déposée la première couche isolante et en ce qu'il comporte les étapes suivantes :
a') solidariser à la première couche isolante une première surface d'un deuxième substrat,
b'1) réaliser à la surface du deuxième substrat opposée à sa première surface une deuxième couche de connexion enterrée en laissant libre au moins une zone dépourvue de matière située à l'aplomb de la zone de contact enterrée de la première couche de connexion enterrée,
b'2) solidariser la deuxième couche de connexion à un troisième substrat par l'intermédiaire d'une troisième couche isolante et,
c') réaliser au moins le premier puits d'interconnexion et simultanément éventuellement un deuxième puits d'interconnexion s'étendant depuis la surface de l'empilement jusqu'à la deuxième zone de contact enterrée.

L'étape c' peut être réalisée à partir d'une surface du troisième substrat, opposée à celle en contact avec ladite troisième couche isolante.

La solidarisation des substrats est de préférence réalisée par scellement moléculaire.

Au moins une étape de solidarisation (notamment b, b2, a', b'2) peut être réalisée par scellement moléculaire.

Le procédé peut être **caractérisé en ce qu'**au moins une zone dépourvue de matière présente une région dépourvue de matière qui entoure le passage d'un puits d'interconnexion.

Le procédé peut être **caractérisé en ce qu'**au moins une zone dépourvue de matière est bordée à sa périphérie par une zone conductrice entourant le passage d'un puits de connexion. Cette zone conductrice peut ainsi être isolée électriquement avant l'étape de remplissage. Cette zone conductrice forme par exemple un anneau électriquement isolé.

Le procédé comporte de préférence une étape unique de remplissage des puits de connexion par un matériau électriquement conducteur pour réaliser lesdites interconnexions.

Le procédé peut comporter une étape de formation de zones conductrices pour réaliser des zones de contact sur les interconnexions.

L'invention sera mieux comprise à la lecture de la description ci-après, en liaison avec les dessins dans lesquels :
- les figures 1a à If illustrent une mise en oeuvre de l'invention dans le cas d'un via entre la surface d'un empilement comportant deux substrats, et une couche de connexion enterrée.
- les figures 2a à 2g illustrent une mise en oeuvre de l'invention dans le cas de deux niveaux d'interconnexion séparés par une couche isolante
- les figures 3a à 3k illustrent une mise en oeuvre préférée de l'invention, avec trois substrats et trois niveaux d'interconnexion
- la figure 4 illustre la propagation latérale du matériau de remplissage des puits
- et les figures 5a et 5b illustrent la mise en oeuvre de murs de confinement pour éviter une telle propagation latérale et le risque de court-circuit y afférent.

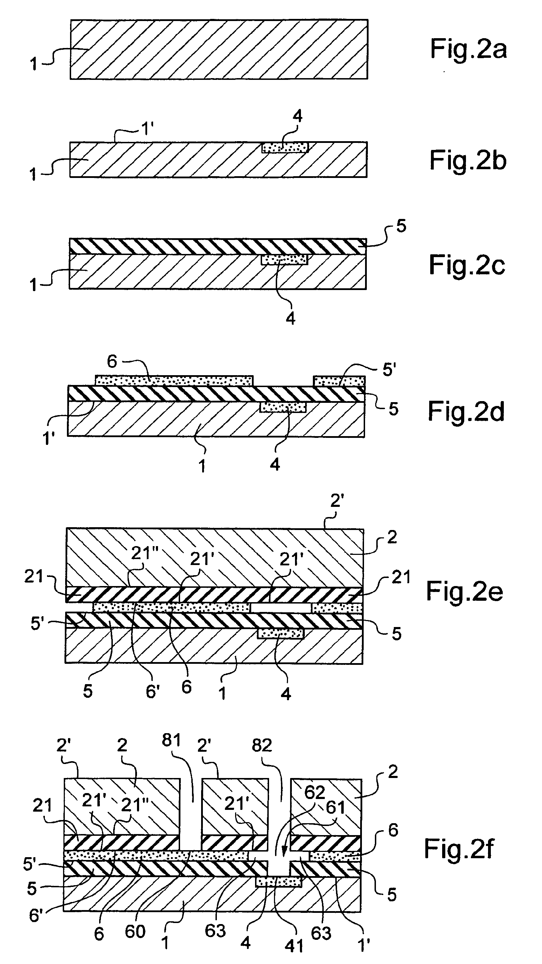

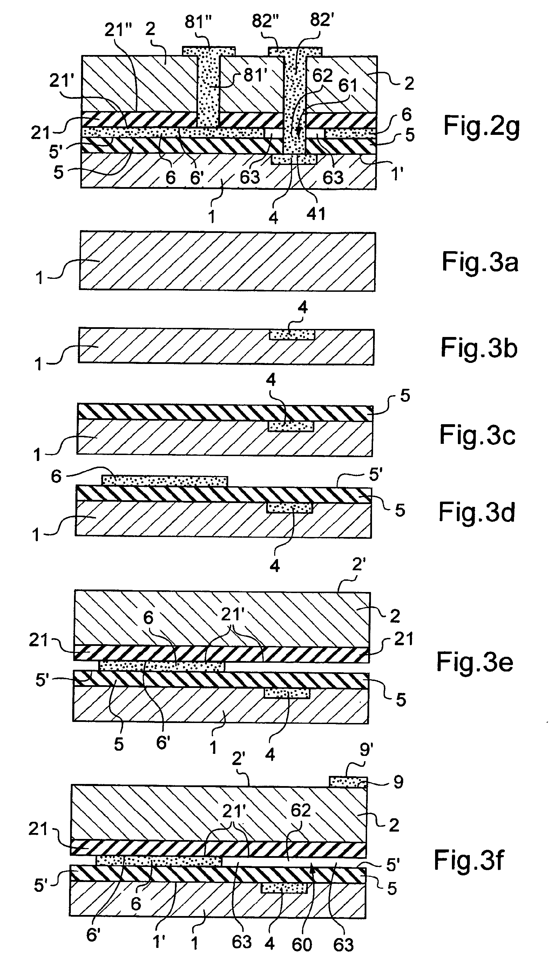

Les figures 2a à 2g illustrent une mise en oeuvre de l'invention avec un composant à deux substrats 1 et 2.

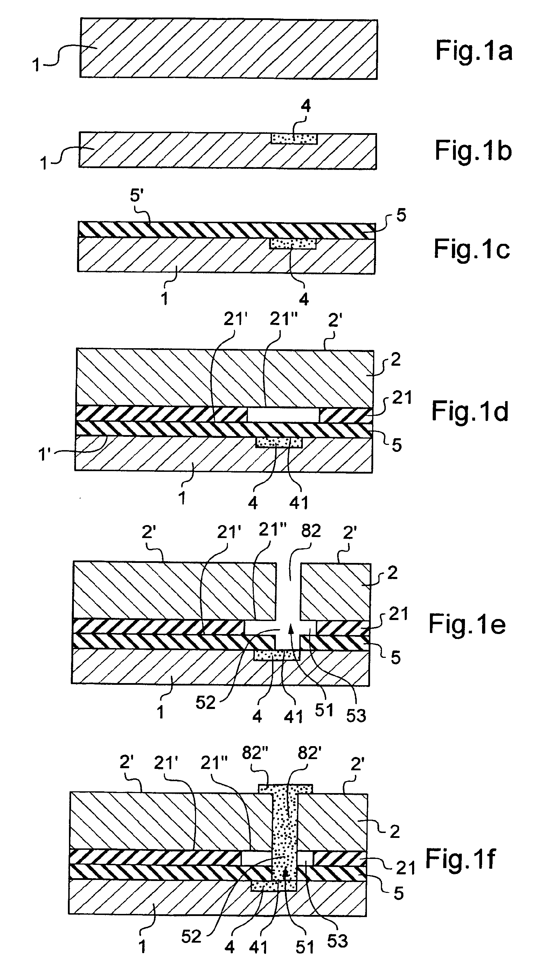

Les figures 1a à 1f illustrent une mise en oeuvre de l'invention avec un composant comportant un empilement de deux substrats 1 et 2, et une interconnexion entre une couche de connexion enterrée 4 et la surface de l'empilement, qui est ici la surface 2' du substrat 2.

On part d'un substrat 1 (figure 1a) par exemple en Si ou bien en Si recouvert d'une couche isolante. Une couche de connexion enterrée présentant au moins un motif conducteur 4 (première couche de connexion) est obtenue par dopage ou gravure puis remplissage par un matériau conducteur (Figure 1b) dans la surface 1' du substrat 1 (ou est réalisée à la surface de celle-ci).

Une couche isolante 5 (Figure 1c) est ensuite déposée sur la surface 1' de manière à recouvrir au moins le périmètre du motif conducteur 4.

Le deuxième substrat 2 présente une couche isolante 21 qui revêt sa surface 21". La couche isolante 21 présente une réserve 51 dépourvue de matière. Elle comporte une région centrale 52 qui est à l'aplomb de la région de prise de contact 41 de la couche conductrice 4, et une région périphérique 53 qui entoure complètement la région centrale 62.

La surface 21' de la couche isolante 21 du deuxième substrat 2 qui est la surface est ensuite solidarisée (Figure 1d) à la surface 5' de la couche isolante 5.

On grave ensuite par gravure plasma (figure 1e) au moins un puits 82 qui traverse le substrat 2, la couche isolante 21, la réserve dépourvue de matière et la couche isolante 5 jusqu'à atteindre au moins une région 41 de prise de contact électrique du motif conducteur 4. Le contour de la région 41 de prise de contact est délimité par le puits 82 et est le même que celui de la région centrale 52 située à l'aplomb de la région 41. Il subsiste autour de cette région centrale 52 une région périphérique 53 dépourvue de matière.

Ensuite, le puits 82 est rempli par un matériau conducteur qui est ensuite planarisé par exemple polysilicium dopé ou bien métal, notamment AlCu, Al, Cu, W, pour réaliser l'interconnexion ou via 82' (figure 1f). Les procédés de dépôt peuvent varier (LPCVD, CVD, epitaxie, etc...). On peut ensuite réaliser à la surface libre 2' du substrat 2, une couche de connexion de surface 82" qui permet une prise de contact électrique pour l'interconnexion 82'.

La gravure du puits 82 peut être réalisée de manière classique par gravure plasma, avec deux plasmas différents, l'un pour attaquer le substrat en général Si (plasma par exemple HBᵣ/Cl₂/O₂ ou SF₆) et l'autre pour attaquer la couche isolante en général SiO₂ (plasma par exemple C₄F₈/Co/O₂). Le matériau conducteur sert de couche d'arrêt.

Lors de la gravure du puits 82, les ions du plasma traversent librement la région centrale 52 de la réserve 51 sans être ralentis, arrêtés ou déviés pour atteindre la région 41 de prise de contact par gravure à travers la couche isolante 5. La section du puits 82 est conservée lors de la gravure à travers la couche isolante.

Dans l'exemple suivant, qui comporte deux niveaux de connexions enterrées, on part d'un substrat 1 (figure 2a) par exemple en Si. Une couche de connexion présentant au moins un motif conducteur 4 (première couche de connexion) est obtenu par dopage ou gravure puis remplissage par un matériau conducteur (Figure 2b) dans la surface 1' du substrat 1 (ou est réalisé à la surface de celle-ci).

Une première couche isolante 5 (Figure 2c) est ensuite déposée sur la surface 1' de manière à recouvrir au moins le périmètre du motif conducteur 4. La couche isolante pourrait être interrompue au-dessus de la première couche conductrice.

Au moins un motif conducteur enterré 6 qui définit une deuxième couche de connexion enterrée (Figure 2d) qui présente une deuxième zone de contact enterrée 60 est ensuite réalisé à la surface de 5' de la couche isolante 5, qui constitue maintenant une surface du substrat 1, en ménageant une réserve 61 dépourvue de matériau.

Cette réserve 61 comporte une région centrale 62 qui est à l'aplomb de la région de prise de contact électrique 41 de la couche conductrice 4, et une région périphérique 63 qui entoure complètement la région centrale 62.

Le deuxième substrat 2 présente une couche isolante 21 qui revêt sa surface 21 ". La surface 21' de la couche isolante 21 du deuxième substrat 2 est ensuite solidarisée (Figure 1e) à la surface 6' du motif conducteur 6 (deuxième niveau de connexion). Cette solidarisation peut être réalisée par scellement moléculaire.

On grave ensuite simultanément par gravure plasma (figure 2f) au moins un puits 81 qui traverse le substrat 2 et la couche isolante 21 jusqu'à atteindre au moins une région 60 de prise de contact d'au moins un motif conducteur 6 et au moins un puits 82 qui traverse le substrat 2, la couche isolante 21 et la couche isolante 5 jusqu'à atteindre au moins une région 41 de prise de contact d'au moins un motif conducteur 4, dont le contour est délimité par le puits 82 et est le même que celui de la région centrale 62 située à l'aplomb de la région 41.

On notera que seul le puits 82 peut être réalisé, notamment dans le cas où le motif conducteur enterré 6 n'est pas destiné à être connecté à la surface de l'empilement.

Ensuite, les puits 81 et 82 sont remplis par un matériau conducteur qui est ensuite planarisé par exemple polysilicium dopé ou métal notamment AlCu, Au, Cu, W. pour réaliser des interconnexions ou vias respectivement 81' et 82' (figure 1g). Les procédés de dépôt peuvent être variés (LPCVD, CVD, epitaxie, etc...). On peut ensuite réaliser à la surface libre 2' du substrat des couches de connexion de surface 81" et 82" qui permettent une prise de contact électrique pour chacune des interconnexions.

La région périphérique 63 permet d'assurer l'isolation électrique entre d'une part, le matériau conducteur de l'interconnexion 82' qui remplit le puits 82, en tenant compte de l'éventuelle propagation latérale dudit matériau conducteur, et d'autre part, le motif conducteur enterré 6.

La gravure des puits peut être réalisée de manière classique par gravure plasma, avec deux plasmas différents, l'un pour attaquer le substrat en général Si (plasma par exemple HBᵣ/Cl₂/O₂ ou SF₆) et l'autre pour attaquer la couche isolante en général SiO₂ (plasma par exemple C₄F₈/CO/O₂). Le matériau conducteur sert de couche d'arrêt.

Lors de la gravure du puits 82, les ions du plasma traversent librement la région centrale 62 sans être ralentis, arrêtés ou déviés pour atteindre la région 41 de prise de contact par gravure à travers la couche isolante 5. La section du puits 82 est conservée lors de la gravure à travers de la couche isolantes.

Les figures 3a à 3k illustrent un mode de mise en oeuvre préféré du procédé selon l'invention dans le cas d'un système micro-électromécanique (« MEMS »).

Les étapes illustrées par les figures 3a à 3e sont les mêmes que les étapes illustrées par les figures 2a à 2e, à la forme près des motifs conducteurs (deuxième niveaux de connexion).

Le procédé se poursuit (Figure 3f) par le dépôt d'une troisième couche de connexion présentant au moins un motif conducteur 9 à la surface 2' du substrat 2.

Ce motif 9 peut être déposé en tout endroit désiré sur la surface à l'exception des régions 91 et 95 destinées au passage des puits 84 et 85 qui définissent ensuite les interconnexions vers les motifs 6 et 4.

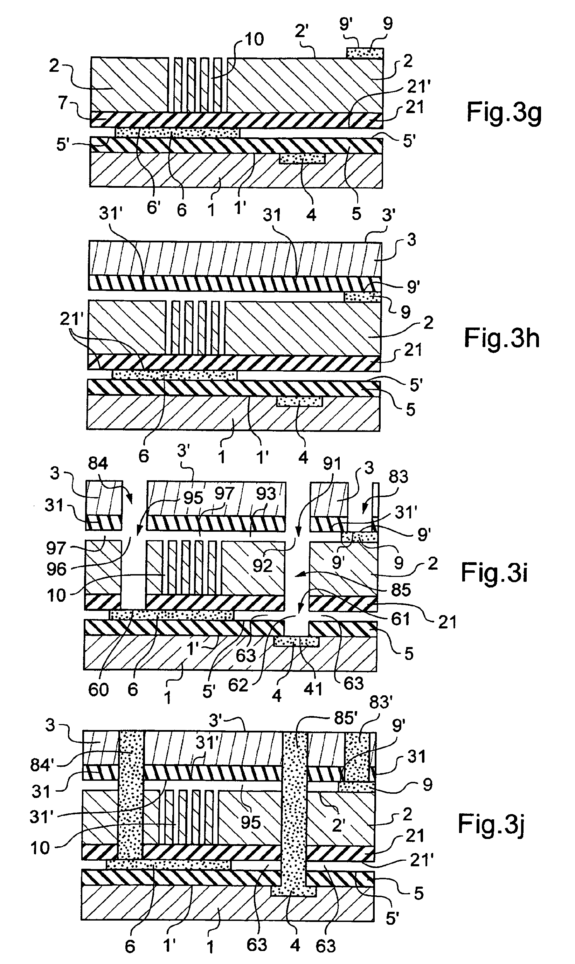

C'est ainsi que la région 91 (puits 85) comporte une région centrale 92 qui surplombe la région de contact 4 et une région périphérique qui l'entoure entièrement, et que la région 95 (puits 84) comporte une région centrale 96 qui surplombe la région de contact 6 et une région périphérique 97 (voir la figure 3i).

Ensuite, on réalise de manière connue dans le substrat 2 (Figure 3g) une structure mécanique 10 pour le micro système électromécanique (MEMS).

On rapporte ensuite (Figure 3h) un substrat 3 pourvu d'une couche isolante 31 qui vient recouvrir la couche de connexion présentant un ou plusieurs motifs conducteurs 9. La surface 31' du troisième substrat 3 (qui est la surface de la couche isolante 31) est solidarisée à la surface 9' du motif conducteur 9, par exemple par scellement moléculaire.

On réalise ensuite (Figure 3i) des puits 83, 84 et 85 qui atteignent respectivement le ou les motifs conducteurs 9 à travers successivement le substrat 3 et la couche isolante 31, le ou les motifs conducteurs 6 à travers successivement le substrat 3, la couche isolante 31, le substrat 2 et la couche isolante 21, et enfin le ou les motifs conducteurs 4 à travers successivement le substrat 3, la couche isolante 31, le substrat 2 et les couches isolantes 21 et 5.

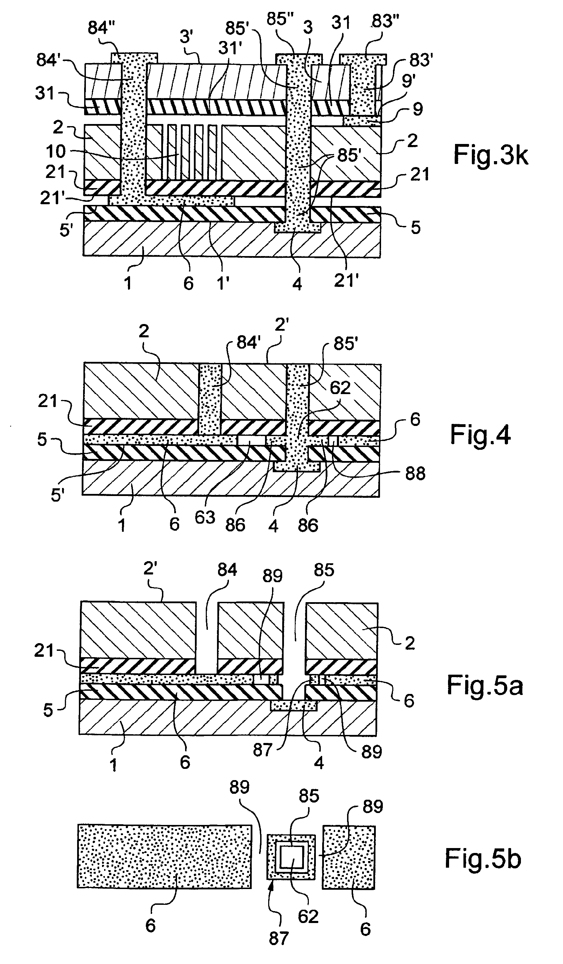

On remplit ensuite (figure 3j) les puits 83, 84 et 85 par un matériau conducteur pour former les interconnexions 83', 84' et 85' qui permettent de connecter électriquement les motifs conducteurs 4, 6 et 9, à partir de la surface 3' du substrat 3 sur laquelle on dépose ensuite à cet effet (figure 3k) les régions de contact 83", 84" et 85" pour former des prises de contact électrique.

Les régions périphériques 63, 93 et 97 sont dimensionnées pour éviter les courts-circuits avec les régions 6 et 9 par le matériau conducteur qui définit les interconnexions 83', 84' et 85'.

En effet, lors de la réalisation de simultanée de ces interconnexions, le matériau conducteur tend à se propager latéralement comme illustré à la figure 4. La région 62 a la même section que le puits 85. La région 63 qui l'entoure doit être prévue suffisamment large pour que le matériau 86 en débord périphérique reste espacé du motif conducteur 6 par un espace dépourvu de matière 88 pour éviter tout court-circuit.

Les figures 5a et 5b illustrent une solution permettant de remédier au problème du débord latéral du matériau conducteur qui remplit les puits.

Il s'agit d'entourer la région centrale par exemple 62 d'un anneau de confinement conducteur 87 qui sert de couche d'arrêt. Cet anneau conducteur 87 est espacé du motif conducteur (ici 6) par un espace vide 89 pour éviter les courts-circuits.

Cette solution convient tout particulièrement aux interconnexions de densité élevée.

On notera que dans un but de simplification, on a représenté un seul puits et une seule interconnexion (ou via) par couche de connexion, mais il est bien entendu possible de réaliser plus d'une interconnexion pour une couche de connexion donnée pour plusieurs motifs conducteurs de cette couche de connexion qui sont électriquement indépendants entre eux et qu'il s'agit de connecter électriquement à la surface du composant.

On notera également que les différentes couches de connexion peuvent être disposées différemment de ce qui a été décrit.

Le procédé peut également permettre de réaliser en une seule étape des puits traversant au moins un substrat vers au moins deux couches de connexion séparées par au moins une couche isolante, puits qui seront ensuite remplis simultanément par un matériau conducteur, pour réaliser seulement une portion d'interconnexion. Cette portion qui pourra ensuite être complétée par exemple en réalisant ultérieurement des puits alignés avec les précédents à travers un autre substrat, puits qui seront ensuite remplis de matériau conducteur pour réaliser une interconnexion.

La technique décrite permet de simplifier de manière significative la suite des étapes de fabrication de dispositifs MEMS ou NEMS (« système nano électro-mécanique ») complexes comportant un empilement de plusieurs substrats. Dans l'exemple des figures 3a à 3j, l'invention permet d'économiser environ 25% du nombre des étapes, par rapport à l'état de l'art qui consiste à réaliser des interconnexions à chaque dépôt/assemblage d'une nouvelle couche.

## Revendications

1. Procédé de réalisation d'au moins un puits d'interconnexion destiné à permettre la réalisation d'un via conducteur entre au moins deux couches de connexion d'un composant comprenant un empilement d'au moins un premier et un deuxième substrats isolés électriquement entre eux, le procédé comprenant la définition d'au moins une zone de contact de surface d'une couche de connexion de surface (82") réalisée sur une surface de l'empilement et d'au moins une première zone de contact (41) enterrée dans l'empilement correspondant à une région de prise de contact électrique d'une première couche de connexion enterrée (4) du premier substrat, **caractérisé en ce qu'**au moins une zone dépourvue de matière (51, 61) est disposée entre le premier (1) et le deuxième (2) substrats et **en ce qu'**il comporte une étape de réalisation par gravure plasma à partir de ladite surface (2', 3') de l'empilement d'au moins un premier puits d'interconnextion (82) traversant au moins le deuxième substrat (2) et s'étendant entre la zone de contact de surface (82", 85") et la première zone de contact enterrée (41) et traversant la zone dépourvue de matière (51, 61), ainsi qu'une première couche isolante (5) qui recouvre la première couche de connexion enterrée (4).

2. Procédé selon la revendication 1, **caractérisé en ce qu'**il comporte une étape de remplissage du puits d'interconnexion (82, 85) par un matériau conducteur (82', 85') pour former un via conducteur et une étape de réalisation de ladite couche de connexion de surface (82"), le via conducteur reliant électriquement par leurs dites zones de contact la première couche de connexion enterrée (4) à la couche de connexion de surface (82").

3. Procédé selon la revendication 1, **caractérisé en ce que** la première couche de connexion enterrée (4) est ménagée dans une surface du premier substrat (1) sur laquelle est ensuite déposée la première couche isolante (5) et **en ce qu'**il comporte les étapes suivantes :
a) après le dépôt de la première couche isolante (5), déposer sur celle-ci au moins une deuxième couche de connexion enterrée (6) comportant une deuxième zone de contact enterrée (60), en laissant libre au moins une première zone dépourvue de matière (61) pour le passage d'un via conducteur destiné à la première zone de contact enterrée (41) de la première couche de connexion enterrée (4),
b) solidariser la deuxième couche de connexion enterrée (6) au deuxième substrat semiconducteur (2), par l'intermédiaire d'une deuxième couche isolante (21),
c) réaliser au moins ledit premier (82, 85) puits d'interconnexion.

4. Procédé selon la revendication 3, **caractérisé en ce que** c comporte également la réalisation d'un deuxième puits d'interconnexion (81) s'étendant depuis ladite surface (2') de l'empilement jusqu'à la deuxième zone de contact enterrée (60) de la deuxième couche de connexion enterrée (6).

5. Procédé selon une des revendications 3 ou 4, **caractérisé en ce que** l'étape c est réalisée à partir d'une surface (2') du deuxième substrat (2), opposée à celle en contact avec ladite deuxième couche isolante (21).

6. Procédé selon la revendication 3, **caractérisé en ce qu'**il met en oeuvre entre b et c :
b1) réaliser à ladite surface (2') du deuxième substrat (2) qui est opposée à ladite surface en contact avec la deuxième couche isolante (21) au moins un couche de connexion enterrée (9) présentant une troisième zone de contact enterrée (9') en laissant libre au moins une zone dépourvue de matière (91, 95) située à l'aplomb des zones de contact enterrées (41, 60) de chacun des première (4) et deuxième (6) couches de connexion enterrées (4, 6),
b2) solidariser la troisième couche de connexion enterrée (9) à un troisième substrat (3) par l'intermédiaire d'une troisième couche isolante (31).

7. Procédé selon la revendication 6, **caractérisé en ce que** l'étape c) comporte la réalisation simultanée d'au moins un premier (85), un deuxième (84) et/ou un troisième (83) puits d'interconnexion pour au moins une des première (4), deuxième (6) et troisième zones de contact (9).

8. Procédé selon une des revendications 6 ou 7, **caractérisé en ce que** l'étape c est réalisée à partir d'une surface (3') du troisième substrat (3), opposée à celle en contact avec ladite troisième couche isolante (31).

9. Procédé selon la revendication 1, **caractérisé en ce que** la première couche de connexion enterrée (4) est ménagée dans une surface du premier substrat (1) sur laquelle est ensuite déposée la première couche isolante (5) et **en ce qu'**il comporte les étapes suivantes :
a') solidariser à la première couche isolante (5) une première surface (2') d'un deuxième substrat (2),
b'1) réaliser à la surface du deuxième (2) substrat opposée à sa première surface une deuxième couche de connexion enterrée (9) en laissant libre au moins une zone dépourvue de matière (91) située à l'aplomb de la zone de contact enterrée (41) de la première couche de connexion enterrée (4),
b'2) solidariser la deuxième couche de connexion enterrée (9) à un troisième substrat (3) par l'intermédiaire d'une troisième couche isolante (31),
c') réaliser au moins le premier puits d'interconnexion (82).

10. Procédé selon la revendication 9, **caractérisé en ce qu'**il comporte également la réalisation d'un deuxième puits d'interconnexion s'étendant depuis la surface (3') de l'empilement jusqu'à la deuxième zone de contact enterrée (9').

11. Procédé selon une des revendications 9 ou 10, **caractérisé en ce que** l'étape c') est réalisée à partir d'une surface (3') du troisième substrat (3), opposée à celle en contact avec de ladite troisième couche isolante (31).

12. Procédé selon une des revendications 3 à 11, **caractérisé en ce qu'**au moins une dite étape de solidarisation est réalisée par scellement moléculaire.

13. Procédé selon une des revendications 1 ou 2, **caractérisé en ce que** lesdits substrats sont solidarisés entre eux par scellement moléculaire.

14. Procédé selon une des revendications précédentes, **caractérisé en ce qu'**au moins une zone dépourvue de matière présente une région dépourvue de matière (63, 88) qui entoure le passage d'un puits d'interconnexion (83, 84, 85).

15. Procédé selon une des revendications précédentes, **caractérisé en ce qu'**au moins une zone dépourvue de matière est bordée à sa périphérie par une zone conductrice (87) entourant le passage d'un puits de connexion (83, 84, 85), cette zone conductrice étant isolée électriquement avec l'étape de remplissage.

16. Procédé selon une des revendications précédentes, **caractérisé en ce qu'**il comporte une étape unique de remplissage des puits de connexion (83, 84, 85) par un matériau électriquement conducteur pour réaliser lesdites interconnexions (83', 84', 85').

## Patentansprüche

1. Verfahren zur Realisierung wenigstens einer Verbindungsbohrung, welche dazu bestimmt ist, die Realisierung einer Durchkontaktierung zwischen wenigstens zwei Verbindungsschichten einer Komponente zu ermöglichen, welche einen Stapel von wenigstens einem ersten und einem zweiten voneinander elektrische isolierten Substrat umfasst, wobei das Verfahren das Definieren wenigstens einer Oberflächenkontaktzone einer Oberflächenverbindungsschicht (82"), welche auf einer Oberfläche des Stapels realisiert ist, und wenigstens einer ersten in dem Stapel eingebetteten Kontaktzone (41), welche einem Bereich zur elektrischen Kontaktierung einer ersten eingebetteten Verbindungsschicht (4) des ersten Substrats entspricht, umfasst, **dadurch gekennzeichnet, dass** wenigstens eine von Material freie Zone (51, 61) zwischen dem ersten (1) und dem zweiten (2) Substrat angeordnet ist, und dass es einen Schritt zur Realisierung, durch Plasmagravur ausgehend von der Oberfläche (2', 3') des Stapels, wenigstens einer ersten Verbindungsbohrung (82), welche durch wenigstens das zweite Substrat (2) verläuft und sich in die Oberflächenkontaktzone (82'', 85'') und die erste eingebettete Kontaktzone (41) erstreckt und durch die von Material freie Zone (51, 61) verläuft, sowie einer ersten isolierenden Schicht (5), welche die erste eingebettete verbindungsschicht (4) bedeckt, umfasst.

2. Verfahren nach Anspruch 1, **dadurch gekennzeichnet, dass** es einen Schritt eines Füllens der Verbindungsbohrung (82, 85) durch ein leitendes Material (82', 85'), um eine Durchkontaktierung auszubilden, und einen Schritt einer Realisierung der Oberflächenverbindungsschicht (82'') umfasst, wobei die Durchkontaktierung über deren Kontaktzone die erste eingebettete Verbindungsschicht (4) mit der oberflächenverbindungsschicht (82") elektrisch verbindet.

3. Verfahren nach Anspruch 1, **dadurch gekennzeichnet, dass** die erste eingebettete Verbindungsschicht (4) in einer Oberfläche des ersten Substrats (1) ausgebildet ist, auf welcher dann die erste isolierende Schicht (5) aufgebracht wird, und dass es die folgenden Schritte umfasst:
a) nach dem Aufbringen der ersten isolierenden Schicht (5), Aufbringen auf derselben wenigstens einer zweiten eingebetteten Verbindungsschicht (6), welche eine zweite eingebettete Kontaktzone (60) umfasst, wobei wenigstens eine erste von Material freie Zone (61) frei gelassen wird für den Durchgang einer Durchkontaktierung, welche für die erste eingebettete Kontaktzone (41) der ersten eingebetteten Verbindungsschicht (4) bestimmt ist,
b) Befestigen der zweiten eingebetteten Verbindungsschicht (6) über eine zweite isolierende Schicht (21) auf dem zweiten Halbleitersubstrat (2),
c) Realisieren wenigstens der ersten Verbindungsbohrung (82, 85).

4. Verfahren nach Anspruch 3, **dadurch gekennzeichnet, dass** es außerdem das Realisieren einer zweiten Verbindungsbohrung (81) umfasst, welche sich ausgehend von der Oberfläche (2') des Stapels bis zu der zweiten eingebetteten Kontaktzone (60) der zweiten eingebetteten Verbindungsschicht (6) erstreckt.

5. Verfahren nach einem der Ansprüche 3 oder 4, **dadurch gekennzeichnet, dass** der Schritt c ausgehend von einer Oberfläche (2') des zweiten Substrats (2), welche derjenigen im Kontakt mit der zweiten isolierenden Schicht (21) gegenüberliegt, realisiert wird.

6. Verfahren nach Anspruch 3, **dadurch gekennzeichnet, dass** es außerdem zwischen b und c einsetzt:
b1) Realisieren an der Oberfläche (2') des zweiten Substrats (2), welche der Oberfläche im Kontakt mit der zweiten isolierenden Schicht (21) gegenüberliegt, wenigstens einer eingebetteten Verbindungsschicht (9), welche eine dritte eingebettete Kontaktzone (9') aufweist, indem wenigstens eine von Material freie Zone (91, 95), welche sich im Lot der eingebetteten Kontaktzone (41, 60) von jeder der ersten (4) und zweiten (6) eingebetteten Verbindungsschichten (4, 6) befindet, frei gelassen wird,
b2) Befestigen der dritten eingebetteten Verbindungsschicht (9) über eine dritte isolierende Schicht (31) an einem dritten Substrat (3).

7. Verfahren nach Anspruch 6, **dadurch gekennzeichnet, dass** der Schritt c) die gleichzeitige Realisierung wenigstens einer ersten (85), einer zweiten (84) und/oder einer dritten (83) Verbindungsbohrung für wenigstens eine der ersten (4), zweiten (6) und dritten Kontaktzonen (9) umfasst.

8. Verfahren nach einem der Ansprüche 6 oder 7, **dadurch gekennzeichnet, dass** der Schritt c ausgehend von einer Oberfläche (3') des dritten Substrats (3), welche derjenigen im Kontakt mit der dritten isolierenden Schicht (31) gegenüberliegt, realisiert wird.

9. Verfahren nach Anspruch 1, **dadurch gekennzeichnet, dass** die erste eingebettete Verbindungsschicht (4) in einer Oberfläche des ersten Substrats (1) ausgebildet wird, auf welcher dann die erste isolierende Schicht (5) aufgebracht wird, und dass es die folgenden Schritte umfasst:
a') Befestigen einer ersten Oberfläche (2') eines zweiten Substrats (2) an der ersten isolierenden Schicht (5),
b'1) Realisieren an der Oberfläche des zweiten Substrats (2), welche seiner ersten Oberfläche gegenüberliegt, einer zweiten eingebetteten Verbindungsschicht (9), indem wenigstens eine von Material freie Zone (91), welche sich im Lot der eingebetteten Kontaktzone (41) der ersten eingebetteten befindet, freigelassen wird,
b'2) Befestigen der zweiten eingebetteten Verbindungsschicht (9) über eine dritte isolierende Schicht (31) an einem dritten Substrat (3),
c') Realisieren wenigstens der ersten Verbindungsbohrung (82).

10. Verfahren nach Anspruch 9, **dadurch gekennzeichnet, dass** es außerdem das Realisieren einer zweiten Verbindungsbohrung umfasst, welche sich ausgehend von der Oberfläche (3') des stapels bis zu der zweiten eingebetteten Kontaktzone (9') erstreckt.

11. Verfahren nach einem der Ansprüche 9 oder 10, **dadurch gekennzeichnet, dass** der Schritt c) ausgehend von einer Oberfläche (3') des dritten Substrats (3) realisiert wird, welche derjenigen im Kontakt mit der dritten isolierenden Schicht (31) gegenüberliegt.

12. Verfahren nach einem der Ansprüche 3 bis 11, **dadurch gekennzeichnet, dass** wenigstens einer der genannten Befestigungsschritte durch eine Molekularversiegelung realisiert ist.

13. Verfahren nach Anspruch 1 oder 2, **dadurch gekennzeichnet, dass** die Substrate durch Molekularversiegelung aneinander befestigt sind.

14. Verfahren nach einem der vorhergehenden Ansprüche, **dadurch gekennzeichnet, dass** wenigstens eine von Material freie Zone einen von Material freien Bereich (63, 88) aufweist, welcher den Durchgang einer Verbindungsbohrung (83, 84, 85) umgibt.

15. Verfahren nach einem der vorhergehenden Ansprüche, **dadurch gekennzeichnet, dass** wenigstens eine von Material freie Zone an ihrem Rand von einer leitenden Zone (87) begrenzt ist, welche den Durchgang einer Verbindungsbohrung (83, 84, 85) umgibt, wobei diese leitende Zone mit dem Füllschritt elektrisch isoliert wird.

16. Verfahren nach einem der Vorhergehenden Ansprüche, **dadurch gekennzeichnet, dass** des einen einzigen Schritt eines Füllens der Verbindungsbohrungen (83, 84, 85) durch ein elektrisch leitendes Material umfasst, um die Durchkontaktierungen (83', 84', 85') zu realisieren.

## Claims

1. A process for producing at least one interconnecting well intended to make possible the achievement of a conductive pathway between at least two connection layers of a component comprising a stack of at least one first substrate and one second substrate which are electrically insulated from one another, the process comprising the definition of at least one surface contact region of a surface connection layer (82") formed over a surface of the stack and of at least one first contact region (41) embedded in the stack corresponding to an electrical contact region of a first embedded connection layer (4) of the first substrate, wherein at least one region devoid of material (51, 61) is positioned between the first substrate (1) and the second substrate (2) and which comprises a stage of producing, by plasma etching starting from said surface (2', 3') of the stack, at least one first interconnecting well (82) which passes through at least the second substrate (2) and which extends between the surface contact region (82", 85") and the first embedded contact region (41) and which passes through the region devoid of material (51, 61), and also a first insulating layer (5) which covers the first embedded connection layer (4).

2. The process as claimed in claim 1, which comprises a stage of filling the interconnecting well (82, 85) with a conductive material (82', 85') in order to form a conductive pathway and a stage of producing said surface connection layer (82"), the conductive pathway electrically connecting, via the said contact regions thereof, the first embedded connection layer (4) to the surface connection layer (82").

3. The process as claimed in claim 1, wherein the first embedded connection layer (4) is put into a surface of the first substrate (1) on which the first insulating layer (5) is subsequently deposited and which comprises the following stages:
a) after the deposition of the first insulating layer (5), depositing, on the latter, at least one second embedded connection layer (6) comprising a second embedded contact region (60), leaving free at least one first region devoid of material (61) for the passage of a conductive pathway intended for the first embedded contact region (41) of the first embedded connection layer (4),
b) rendering the second embedded connection layer (6) integral with the second semiconducting substrate (2) via a second insulating layer (21),
c) producing at least said first interconnecting well (82, 85).

4. The process as claimed in claim 3, wherein c also comprises the production of a second interconnecting well (81) extending from said surface (2') of the stack as far as the second embedded contact region (60) of the second embedded connection layer (6).

5. The process as claimed in either of claims 3 and 4, wherein stage c is carried out starting from a surface (2') of the second substrate (2), opposite that in contact with said second insulating layer (21).

6. The process as claimed in claim 3, which comprises, between b and c:
b1) producing, at said surface (2') of the second substrate (2) which is opposite said surface in contact with the second insulating layer (21), at least one embedded connection layer (9) exhibiting a third embedded contact region (9'), leaving free at least one region devoid of material (91, 95) situated vertically above the embedded contact regions (41, 60) of each of the first (4) and second (6) embedded connection layers (4, 6),
b2) rendering the third embedded connection layer (9) integral with a third substrate (3) via a third insulating layer (31).

7. The process as claimed in claim 6, wherein stage c) comprises the simultaneous production of at least one first interconnecting well (85), one second interconnecting well (84) and/or one third interconnecting well (83) for at least one of the first (4), second (6) and third (9) contact regions.

8. The process as claimed in either of claims 6 and 7, wherein stage c is carried out starting from a surface (3') of the third substrate (3), opposite that in contact with said third insulating layer (31).

9. The process as claimed in claim 1, wherein the first embedded connection layer (4) is put into a surface of the first substrate (1) on which the first insulating layer (5) is subsequently deposited and which comprises the following stages:
a') rendering the first insulating layer (5) integral with a first surface (2') of a second substate (2),
b'1) producing, at the surface of the second substrate (2) opposite its first surface, a second embedded connection layer (9), leaving free at least one region devoid of material (91) situated vertically above the embedded contact region (41) of the first embedded connection layed (4),
b'2) rendering the second embedded connection layer (9) integral with a third substrate (3) visa a third insulating layer (31),
c') producing at least the first interconnecting well (82).

10. The process as claimed in claim 9, which also comprises the production of a second interconnecting well extending from the surface (3') of the stack as far as the second embedded contact region (9').

11. The process as claimed in either of claims 9 and 10, wherein stage c') is carried out starting from a surface (3') of the third substrate (3), opposite that in contact with said third insulating layer (31).

12. The process as claimed in one of claims 3 to 11, wherein at least one said stage of rendering integral is carried out by direct bonding.

13. The process as claimed in either of claims 1 and 2, wherein said substrates are rendered integral with one another by direct bonding.

14. The process as claimed in one of the preceding claims, wherein at least one region devoid of material exhibits a region devoid of material (63, 88) which surrounds the passage of an interconnecting well (83, 84, 85).

15. The process as claimed in one of the preceding claims, wherein at least one region devoid of material is bordered at its periphery by a conductive region (87) surrounding the passage of an interconnecting well (83, 84, 85), this conductive region being electrically insulated with the filling stage.

16. The process as claimed in one of the preceding claims, which comprises a single stage of filling the interconnecting wells (83, 84, 85) with an electrically conductive material in order to produce said interconnections (83', 84', 85').
